# EUROPÄISCHE PATENTANMELDUNG

(11) **EP 3 637 125 A1**
(43) Veröffentlichungstag der Anmeldung: **15.04.2020**
(21) Anmeldenummer: 18199259.5
(22) Anmeldetag: 09.10.2018
(51) Int. Cl.: G01R 33/561, G01R 33/483, G01R 33/56

(54) **MAGNETRESONANZFINGERPRINTING-DATEN-ERFASSUNG MIT UNTERSCHIEDLICHEN FLIPWINKELN FÜR GLEICHZEITIG ANGEREGTE SCHICHTEN**

(71) Anmelder: Siemens Healthcare GmbH, 91052 Erlangen (DE)
(72) Erfinder: Grodzki, David, 91058 Erlangen (DE)

(57) **Zusammenfassung**

Die Erfindung betrifft das Erfassen von mindestens einem quantitativen physiologischen Parameter mit einer Magnetresonanzanlage (10) mittels MR-Fingerprinting. Dabei werden gleichzeitig mehrere Schichten mit verschiedenen Bildgebungsparametern zur Erzeugung von MR-Signalverläufen in jeder der mehreren Schichten angeregt und gleichzeitig die MR-Daten der mehreren Schichten erfasst. Bei dem gleichzeitigen Anregen der mehreren Schichten ist ein Flipwinkel (FW), mit welchem eine der mehreren Schichten angeregt wird, verschieden von einem Flipwinkel (FW), mit welchem eine andere der mehreren Schichten angeregt wird.

## Beschreibung

Die vorliegende Erfindung betrifft die Erfassung von MR-Daten für ein MR-Fingerprinting, wobei gleichzeitig mit verschiedenen Flipwinkeln gearbeitet wird.

Im Gegensatz zu der Computertomografie werden bei der klinischen MR-Bildgebung in der Regel keine quantitativen Pixelwerte physikalischer Parameter, sondern qualitativ gewichtete MR-Bilder erstellt, bei denen zwischen verschiedenen Stoffen ein vorteilhafter Kontrast vorhanden ist. Die Messung quantitativer physikalischer Werte hat demgegenüber einige Vorteile, wie z. B. eine verbesserte Reproduzierbarkeit (auch beim Einsatz verschiedener Scannertypen von unterschiedlichen Herstellern) und damit eine verbesserte Vergleichbarkeit. Aber mit den gängigen Verfahren aus dem Stand der Technik ist die Messung quantitativer physikalischer Werte zum einen vergleichsweise langsam und zum anderen ungenau, so dass diese gängigen Verfahren in der klinischen Bildgebung nur äußerst selten eingesetzt werden.

Ein neueres Verfahren zur Messung quantitativer physikalischer Werte ist das MR-Fingerprinting (MRF), mit welchem in einer Messung pixelweise mehrere physikalische Werte (z.B. T1, T2) gleichzeitig gemessen werden können. Beim MR-Fingerprinting werden bevorzugt mit einem Single-Shot-Verfahren viele MR-Bilder hintereinander akquiriert, wobei pro Pixel bzw. Voxel Messparameter, wie TR, Flipwinkel, usw., geändert werden, so dass abhängig von den physikalischen Eigenschaften des Stoffes pixelweise andere Signalverläufe über die erfassten MR-Bilder hinweg entstehen. Diese Signalverläufe (Fingerabdrücke bzw. Fingerprints) können durch Abgleich mit Datenbanken einem n-Tupel physikalischer Werte zugeordnet werden.

Die durch MR-Fingerprinting erzeugten T1- und T2-Karten können direkt zur Befundung durch den Radiologen oder (da quantitative Karten für Radiologen ungewohnt sind) zur Berechnung synthetischer MR-Bilder mit gewöhnlichen qualitativen Kontrasten benutzt werden. Dies bietet vor allem auch in dem Sinn einen großen Vorteil, da aus dem MR-Fingerprinting-Datensatz viele herkömmliche Kontraste berechnet werden können, wodurch das Verfahren sehr zeitsparend sein kann.

MR-Fingerprinting-Daten können zweidimensional, aber auch dreidimensional akquiriert werden. Eine dreidimensionale Datenerfassung bietet den Vorteil, dass größere Volumen schnell akquiriert werden können. Allerdings treten bei der dreidimensionalen Datenerfassung bisweilen Probleme durch eine K-Raum-Unterabtastung auf.

Insbesondere bei der zweidimensionalen Erfassung von MR-Fingerprinting-Daten kann es aufgrund der im Mittel kurzen Repetitionszeiten und hohen Flipwinkel zu einer Überlastung der Magnetresonanzanlage, genauer des HF-Leistungsverstärkers der Magnetresonanzanlage, kommen. Eine solche Überlastung kann sich durch kleinere maximale Flipwinkel (d.h. der aktuell mögliche maximale Flipwinkel ist aufgrund der Überlastung kleiner als ohne Überlastung) oder im schlimmeren Fall durch Pulse-Clipping äußern. Beim Pulse-Clipping wird eine Amplitude (z.B. eines Gradientenpulses) unter einem bestimmten Schwellenwert gehalten. Zum Beispiel kann ein B1 mit einer Amplitude von 30 µT im Verlauf eines Pulses gefordert sein. Aufgrund der drohenden Überlastung werden aber alle Amplituden unterhalb des Schwellenwertes von 20 µT gehalten, was als Pulse-Clipping bezeichnet wird. Durch dieses "Abschneiden" stimmt die tatsächlich ausgespielte Pulsform nicht mit der geforderten Pulsform überein, was negative Auswirkungen auf die spektralen Eigenschaften, wie Schichtprofil, usw., hat.

Daher stellt sich die vorliegende Erfindung die Aufgabe, eine Überlastung der Magnetresonanzanlage und insbesondere eine Überlastung des HF-Leistungsverstärkers der Magnetresonanzanlage beim MR-Fingerprinting zu vermeiden, ohne dass es z.B. zu Pulse-Clipping kommt.

Erfindungsgemäß wird diese Aufgabe durch ein Verfahren zum Erfassen von mindestens einem quantitativen physikalischen Parameter mit einer Magnetresonanzanlage mittels MR-Fingerprinting nach Anspruch 1, durch eine Magnetresonanzanlage nach Anspruch 7, durch ein Computerprogrammprodukt nach Anspruch 9 und durch einen elektronisch lesbaren Datenträger nach Anspruch 10 gelöst. Die abhängigen Ansprüche definieren bevorzugte und vorteilhafte Ausführungsformen der vorliegenden Erfindung.

Im Rahmen der vorliegenden Erfindung wird ein Verfahren zum Erfassen von einem oder von mehreren quantitativen physiologischen oder physikalischen Parametern eines Untersuchungsobjekts mit einer Magnetresonanzanlage mittels MR-Fingerprinting bereitgestellt. Dabei umfasst das erfindungsgemäße Verfahren folgende Schritte:
- Gleichzeitiges Anregen von mehreren (mindestens zwei) Schichten, wobei mit verschiedenen Bildgebungsparametern zur Erzeugung von MR-Signalverläufen in jeder der Schichten gearbeitet wird. Insbesondere wird in jeder der Schichten für denselben Pixel der jeweiligen Schicht durch die verschiedenen Bildgebungsparameter ein spezifischer MR-Signalverlauf (Fingerprint) des MR-Signals erzeugt.
- Gleichzeitiges Erfassen der MR-Daten der mehreren Schichten, aus denen dann insbesondere für die mehreren Schichten die pixelweisen MR-Signalverläufe (Fingerprints) rekonstruiert werden können.

Bei dem gleichzeitigen Anregen der mehreren Schichten ist dabei ein Flipwinkel, mit welchem eine dieser Schichten angeregt wird, verschieden von einem Flipwinkel, mit welchem eine andere der Schichten angeregt wird. Insbesondere unterscheiden sich demnach die Flipwinkelverläufe von zumindest zwei der gleichzeitig angeregten Schichten.

Das gleichzeitige Anregen und Erfassen mehrerer Schichten wird häufig auch als SMS (Simultaneous Multi Slice) bezeichnet. Das erfindungsgemäße gleichzeitige Anregen von mehreren Schichten und das gleichzeitige Erfassen von MR-Daten aus diesen Schichten ermöglicht, dass MR-Bilder für diese mehreren Schichten rekonstruiert werden können.

Indem während des Anregens und der Erfassung der MR-Daten Bildgebungsparameter, wie Flipwinkel, TR, TE, TI, geändert werden, können für die jeweiligen Schichten quantitative Karten mit physikalischen Größen, wie T1, T2, Off-Resonanz, M0, erstellt werden.

Indem sich die Flipwinkel von zumindest zwei der gleichzeitig angeregten Schichten unterscheiden, kann beispielsweise der Flipwinkel der einen dieser beiden Schichten maximal eingestellt sein, während der Flipwinkel der anderen dieser beiden Schichten unterhalb seines Maximums eingestellt ist. Dadurch ist die Belastung des HF-Leistungsverstärkers vorteilhafterweise geringer, als wenn der Flipwinkel der beiden Schichten auf seinen Maximalwert eingestellt ist.

Gemäß einer bevorzugten Ausführungsform wird ein Flipwinkelverlauf jeder der mehreren Schichten derart eingestellt, dass die Leistung, welche zur Erzeugung der Flipwinkelverläufe für die gleichzeitig angeregten mehreren Schichten benötigt wird und von dem HF-Leistungsverstärker der Magnetresonanzanlage bereitgestellt wird, an die Leistungsgrenzen dieses HF-Leistungsverstärkers angepasst ist. Mit anderen Worten werden damit bei dieser Ausführungsform die Flipwinkelverläufe der mehreren gleichzeitig angeregten Schichten an die Leistungsgrenzen des eingesetzten HF-Leistungsverstärkers angepasst.

Insbesondere können durch diese Anpassung der Flipwinkelverläufe für die gleichzeitig angeregten Schichten an die Leistungsgrenzen des HF-Leistungsverstärkers die Flipwinkelverläufe derart eingestellt werden, dass die Leistungsgrenzen des HF-Leistungsverstärkers niemals überschritten werden. Darüber hinaus können die Flipwinkelverläufe für die gleichzeitig angeregten Schichten derart gewählt werden, dass eine besonders vorteilhafte Auslastung oder Leistungsentnahme des HF-Leistungsverstärkers (z.B. eine möglichst gleichmäßige Leistungsentnahme) erzielt wird.

Gemäß einer weiteren Ausführungsform können die Flipwinkelverläufe der gleichzeitig angeregten Schichten so eingestellt sein, dass beispielsweise immer dann, wenn eine bestimmte dieser Schichten einen besonders hohen Flipwinkel aufweist, eine andere der Schichten einen entsprechend kleineren Flipwinkel aufweist. Beispielsweise kann eine Summe der Flipwinkel, mit welchen die mehreren Schichten zu einem Zeitpunkt angeregt werden, kleiner als ein vorgegebener Schwellenwert sein, welcher in Abhängigkeit von den Leistungsgrenzen des eingesetzten HF-Leistungsverstärkers definiert ist.

Vorteilhafterweise wird der Schwellenwert so gewählt ist, dass die diesen Schwellenwert berücksichtigende Summe der Flipwinkel dazu führt, dass die Leistungsgrenzen des eingesetzten HF-Leistungsverstärkers zu keinem Zeitpunkt überschritten werden. Dadurch ist vorteilhafterweise sichergestellt, dass bei der erfindungsgemäßen Erfassung der MR-Daten die Leistungsgrenzen des HF-Leistungsverstärkers nicht überschritten werden.

Insbesondere kann die Summe der Flipwinkel, mit welchen die gleichzeitig angeregten Schichten angeregt werden, zu jeder Zeit konstant sein.

Wenn die Summe der Flipwinkel zu jeder Zeit konstant ist, sorgen die eingestellten Flipwinkelverläufe vorteilhafterweise für eine gleichmäßige Leistungsanforderung des HF-Leistungsverstärkers.

Erfindungsgemäß ist es allerdings auch möglich, dass die Flipwinkel, mit welchen die Schichten angeregt werden, zu Spitzen bezüglich der Leistungsanforderung an den HF-Leistungsverstärker führen. In diesem Fall sind diese Spitzen und auch die sonstigen Leistungsanforderungen an den HF-Leistungsverstärker vorteilhafterweise so eingestellt, dass es zu keiner Überlastung des HF-Leistungsverstärkers kommt.

Gemäß einer weiteren Ausführungsform können die Flipwinkelverläufe an das in der jeweiligen Schicht zu messende Gewebe oder an den in der jeweiligen Schicht zu messenden Stoff angepasst werden.

Wenn die Bildgebungsparameter einer MR-Fingerprinting-Messung an ein zu messendes Gewebe angepasst werden, indem die erwarteten physikalischen Gewebeeigenschaften berücksichtigt werden, kann vorteilhafterweise beim Erfassen der tatsächlichen physikalischen Eigenschaften dieser Gewebe vorteilhafterweise eine sehr hohe Genauigkeit erzielt werden. Dabei ist es erfindungsgemäß durchaus möglich, den Flipwinkelverlauf einer der gleichzeitig angeregten Schichten an ein Gewebe anzupassen, während der Flipwinkelverlauf einer anderen der gleichzeitig angeregten Schichten an ein anderes Gewebe angepasst wird. Mit anderen Worten können die Flipwinkelverläufe der gleichzeitig angeregten Schichten an dasselbe Gewebe oder unterschiedlich Gewebe angepasst werden.

Bei MR-Messungen des Kopfes eines Untersuchungsobjekts sind häufig an der Schädelbasis des Kopfes deutlich andere Stoffe vorhanden als im oberen Kopfbereich. Daher ist es bei solchen Kopfmessungen durchaus sinnvoll, den Flipwinkelverlauf einer Schicht im Bereich der Schädelbasis an einen anderen Stoff anzupassen als eine Schicht im oberen Kopfbereich.

Erfindungsgemäß ist es auch denkbar, die Anpassung der Flipwinkelverläufe an den zu messenden Stoff erst im Lauf der MR-Fingerprinting-Messung vorzunehmen. Dazu wird beispielsweise in einer ersten Phase des erfindungsgemäßen Verfahrens anhand von Resultaten einer Fingerprinting-Messung pro Schicht jeweils ein oder mehrere Stoffe bestimmt. In einer zweiten Phase des Verfahrens, welche der ersten Phase folgt, kann dann der Flipwinkelverlauf jeder der mehreren gleichzeitig angeregten Schichten abhängig von dem oder den Stoffen eingestellt werden, welche für die jeweilige Schicht in der ersten Phase bestimmt wurden. Dabei ist es denkbar, die MR-Daten in der ersten Phase mit gleichen Einstellungen zu erfassen, sofern dadurch die Leistungsgrenzen des HF-Leistungsverstärkers nicht überschritten werden.

Im Rahmen der vorliegenden Erfindung wird auch eine Magnetresonanzanlage bereitgestellt, welche eine HF-Steuereinheit, einen HF-Leistungsverstärker, eine Gradientensteuereinheit, eine Bildsequenzsteuerung und eine Recheneinheit umfasst. Diese Magnetresonanzanlage ist ausgestaltet, um mindestens einen quantitativen physiologischen oder physikalischen Parameter mittels Fingerprinting zu erfassen. Weiter ist die Magnetresonanzanlage ausgestaltet, um mittels der HF-Steuereinheit und des HF-Leistungsverstärkers gleichzeitig mehrere Schichten mit verschiedenen Bildgebungsparametern zur Erzeugung von MR-Signalverläufen anzuregen und um mittels der Gradientensteuereinheit und der Bildsequenzsteuerung MR-Daten der mehreren Schichten für eine MR-Fingerprinting-Messung gleichzeitig zu erfassen. Die Magnetresonanzanlage ist ausgestaltet, um bei dem gleichzeitigen Anregen der mehreren Schichten einen Flipwinkel, mit welchem eine der mehreren Schichten angeregt wird, unterschiedlich zu einem Flipwinkel einzustellen, mit welchem eine andere der mehreren Schichten angeregt wird.

Die Vorteile der erfindungsgemäßen Magnetresonanzanlage entsprechen im Wesentlichen den Vorteilen des erfindungsgemäßen Verfahrens, welche vorab im Detail beschrieben worden sind, so dass hier auf eine Wiederholung verzichtet wird.

Des Weiteren beschreibt die vorliegende Erfindung ein Computerprogrammprodukt, insbesondere eine Software, welche man in einen Speicher einer programmierbaren Steuereinrichtung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuereinrichtung läuft. Dabei benötigt das Computerprogrammprodukt eventuell Programmmittel, z.B. Bibliotheken und Hilfsfunktionen, um die entsprechenden Ausführungsformen des Verfahrens zu realisieren. Mit anderen Worten soll mit dem auf das Computerprogrammprodukt gerichteten Anspruch insbesondere eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert und gebunden oder der nur interpretiert werden muss, oder um einen ausführbaren Softwarecode handeln, der zur Ausführung nur noch in die entsprechende Recheneinheit bzw. Steuereinrichtung zu laden ist.

Schließlich offenbart die vorliegende Erfindung einen elektronisch lesbaren Datenträger, z.B. eine DVD, ein Magnetband, eine Festplatte oder einen USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuereinrichtung bzw. Recheneinheit einer Magnetresonanzanlage gespeichert werden, können alle erfindungsgemäßen Ausführungsformen des vorab beschriebenen Verfahrens durchgeführt werden.

Im Folgenden wird die vorliegende Erfindung anhand erfindungsgemäßer Ausführungsformen mit Bezug zu den Figuren im Detail beschrieben.
Fig. 1 stellt eine erfindungsgemäße Magnetresonanzanlage dar.
Fig. 2 stellt eine MR-Fingerprinting-Datenerfassung dar.
Fig. 3 stellt den Flussplan einer erfindungsgemäßen Ausführungsform dar.

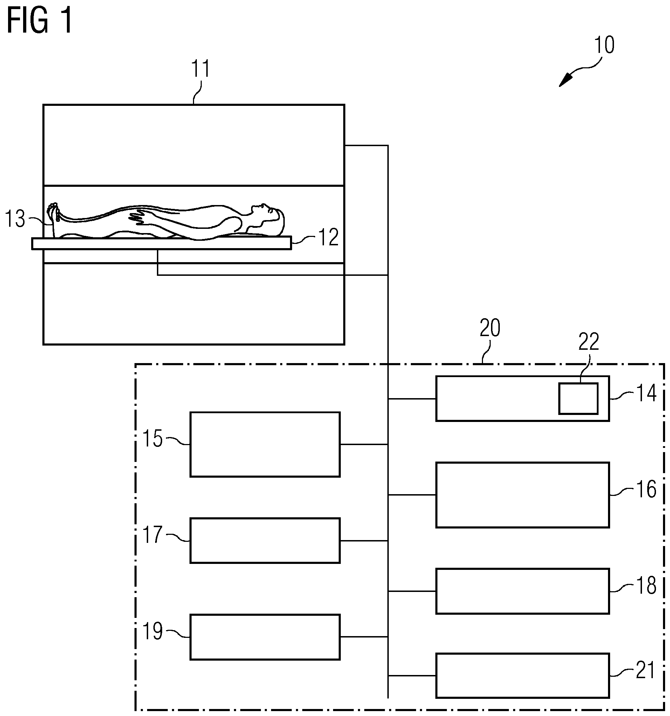

Mit Bezug zu Fig. 1 wird eine Magnetresonanzanlage 10 dargestellt, mit der, wie nachfolgend erläutert wird, erfindungsgemäß MR-Fingerprinting-Daten erfasst werden. Die Magnetresonanzanlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale bzw. MR-Daten aus der Untersuchungsperson 13 aufzunehmen. Die zur Signalaufnahme verwendeten Spulen wie eine Ganzkörperspule oder Lokalspulen sind aus Übersichtlichkeitsgründen nicht dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die Magnetresonanzanlage 10 weist weiterhin eine Steuereinheit 20 auf, die zur Steuerung der Magnetresonanzanlage 10 verwendet werden kann. Die Steuerung 20 weist eine Gradientensteuereinheit 15 zur Steuerung und Schaltung der notwendigen Magnetfeldgradienten auf. Eine HF-Steuereinheit 14 mit HF-Leistungsverstärker 22 ist für die Steuerung und Generierung der HF-Pulse zur Auslenkung der Magnetisierung vorgesehen. Eine Bildsequenzsteuerung 16 steuert die Abfolge der Magnetfeldgradienten und HF-Pulse und damit indirekt die Gradientensteuereinheit 15 und die HF-Steuereinheit 14. Über eine Eingabeeinheit 17 kann eine Bedienperson die Magnetresonanzanlage 10 steuern, und auf einer Anzeigeeinheit 18 können MR-Bilder und sonstige zur Steuerung notwendige Informationen angezeigt werden. Eine Recheneinheit 19 mit mindestens einer Prozessoreinheit (nicht gezeigt) ist vorgesehen zur Steuerung der verschiedenen Einheiten in der Steuereinheit 20 und zur Durchführung von Rechenoperationen. Weiterhin ist eine Speichereinheit 21 vorgesehen, in der beispielsweise Programmmodule bzw. Programme abgespeichert sein können, die, wenn sie von der Recheneinheit 19 bzw. ihrer Prozessoreinheit ausgeführt werden, den Ablauf der Magnetresonanzanlage 10 steuern können. Die Recheneinheit 19 ist ausgebildet, um aus den erfassten MR-Signalen physikalische Parameter zu bestimmen oder MR-Bilder zu berechnen.

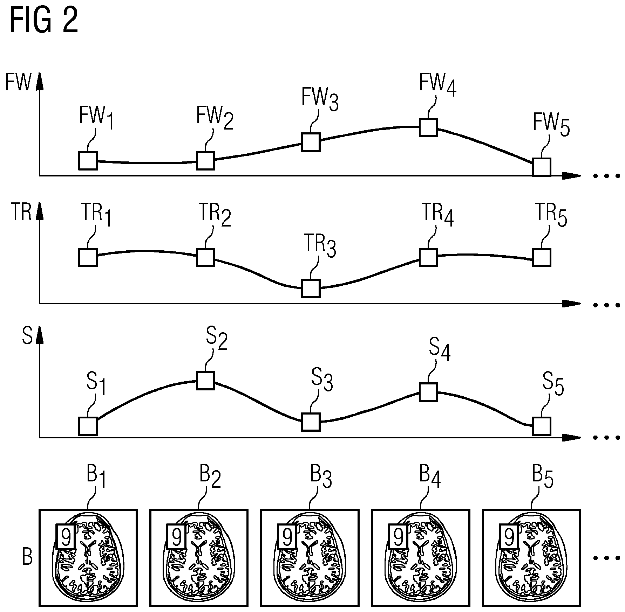

Anhand der Fig. 2 wird das erfindungsgemäße Erfassen von MR-Daten mittels Fingerprinting erläutert.

Im Rahmen der MR-Fingerprinting-Messung wird ein MR-Signalverlauf (d.h. ein Verlauf eines MR-Signals S) pro Voxel 9 erstellt. Dazu ist die Erstellung mehrerer MR-Bilder B₁-B₅ derselben Schicht erforderlich. Zur Erstellung der MR-Bilder B₁-B₅ wird ein vorbestimmter Volumenabschnitt der jeweiligen Schicht mehrfach abgetastet, indem der mit dem Volumenabschnitt korrespondierende K-Raum mehrfach abgetastet wird, um MR-Daten zu erfassen. Dazu werden bei der jeweiligen Abtastung des K-Raums verschiedene Bildgebungsparameter oder Messparameter (Flipwinkel FW, Repetitionszeit TR) verwendet.

Der Verlauf des Flipwinkels FW ist in Fig. 2 für eine Schicht anhand der Bezugszeichen FW₁ bis FW₅ und der Verlauf der Repetitionszeit TR anhand der Bezugszeichen TR₁ bis TR₅ zu erkennen. Mit diesen für den jeweiligen K-Raum individuellen Messparametern FW, TR wird der jeweilige K-Raum abgetastet. Durch eine Rekonstruktion der so erfassten MR-Daten werden die MR-Bilder B₁ bis B₅ rekonstruiert, wobei das MR-Signal S₁ bis S₅ desselben Voxels oder Pixels 9 für alle rekonstruierten MR-Bilder B₁ bis B₅ in Form eines MR-Signal-Verlaufs in Fig. 2 dargestellt ist.

Die in Fig. 1 dargestellte Magnetresonanzanlage 10 ist ausgestaltet um mittels Fingerprinting einen oder mehrere quantitative physikalische Parameter von Voxeln in einem Volumenabschnitt eines Untersuchungsobjekts anhand des jeweils rekonstruierten MR-Signalverlaufs S₁ bis S₅ zu bestimmen. Dazu regt die Magnetresonanzanlage 10 mit Hilfe ihrer HF-Steuereinheit 14 und des HF-Leistungsverstärker 22 gleichzeitig mehrere Schichten des Volumenabschnitts an, um dann MR-Daten der Schichten zu erfassen. Dabei ist zumindest zu einem Zeitpunkt der Flipwinkel der einen der mehreren gleichzeitig angeregten Schichten verschieden von dem Flipwinkel der anderen der mehreren gleichzeitig angeregten Schichten. Mit anderen Worten stimmt der in Fig. 2 für die eine der gleichzeitig angeregten Schichten dargestellte Flipwinkelverlauf FW₁ - FW₅ zumindest zu einem Zeitpunkt nicht mit dem für die andere der mehreren gleichzeitig angeregten Schichten gewählten Flipwinkelverlauf überein.

Anhand der rekonstruierten MR-Bilder B₁ bis B₅ wird dann der MR-Signalverlauf S₁ bis S₅ für ein bestimmtes Voxel 9 erstellt. Anhand dieses MR-Signalverlaufs S₁ bis S₅ wird eine oder werden mehrere physikalische Eigenschaften des Voxels 9 (z. B. eine physikalische Größe oder ein in dem Voxel vorhandener Stoffanteil) bestimmt, indem beispielsweise in einer Datenbank die dem jeweiligen MR-Signalverlauf S1 bis S5 zugeordneten physikalischen Eigenschaften gesucht werden. In dieser Datenbank sind für die verschiedensten MR-Signalverläufe jeweils die zugeordneten physikalischen Eigenschaften gespeichert.

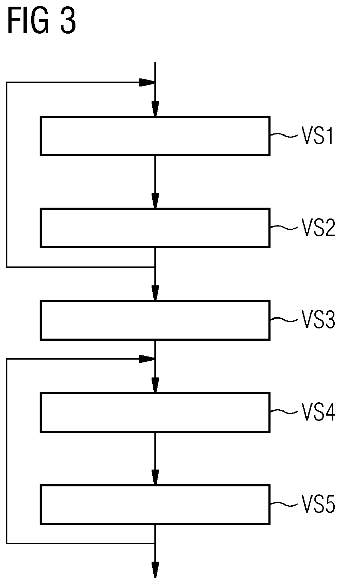

In Fig. 3 ist der Flussplan einer erfindungsgemäßen Ausführungsform zum Erfassen von MR-Fingerprinting-Daten dargestellt.

Im Schritt VS1 werden gleichzeitig mehrere Schichten mit verschiedenen Flipwinkeln angeregt, wobei im folgenden Schritt VS2 MR-Daten in den Schichten erfasst werden. Die beiden Schritte VS1, VS2 werden mehrfach wiederholt, so dass für dasselbe Voxel 9 (siehe Fig. 2) mit individuellen Bildgebungsparametern FW, TR der zugehörige K-Raum mehrfach abgetastet und jeweils MR-Daten erfasst werden. Ausgehend von den erfassten MR-Daten werden im folgenden Schritt VS3 mehrere MR-Bilder B1 bis B5 (siehe Fig. 2) für jede der mehreren gleichzeitig angeregten Schichten rekonstruiert, so dass für dasselbe Voxels 9 (und beliebig viele andere Voxel) in der jeweiligen Schicht mehrere MR-Signale S₁ bis S₅ rekonstruiert werden. Anhand des jeweiligen MR-Signalverlaufs (Fingerprints) des jeweiligen Voxels werden dann im Schritt VS3 die Gewebeeigenschaften oder Stoffeigenschaften dieses Voxels bestimmt.

Anhand dieser Gewebeeigenschaften oder Stoffeigenschaften werden die Bildgebungsparameter (z.B. der Flipwinkel) der jeweiligen Schicht neu eingestellt, wobei darauf geachtet wird, dass zum selben Zeitpunkt zumindest die Flipwinkel von zwei gleichzeitig angeregten Schichten unterschiedlich sind. Die neuen Bildgebungsparameter werden dabei insbesondere derart an die vorher ermittelten Stoffeigenschaften angepasst, dass mit den neuen Bildgebungsparameter MR-Signalverläufe rekonstruiert werden können, ausgehend von welchen noch besser (als mit den zuerst eingestellten Bildgebungsparametern) die physikalischen Eigenschaften oder Stoffeigenschaften des entsprechenden Voxels bestimmten werden können. Mit diesen neuen Bildgebungsparametern werden dann im Schritt VS4 gleichzeitig mehrere Schichten mit jeweils verschiedenen Flipwinkeln angeregt. Der Schritt VS4 entspricht somit dem Schritt VS1, nur dass in der Regel im Schritt VS4 andere Bildgebungsparameter eingesetzt werden als im Schritt VS1. In dem Schritt VS4 folgenden Schritt VS5 werden die MR-Daten in den Schichten für das Fingerprinting erfasst.

Die Schritte VS4 und VS5 werden mehrfach ausgeführt. Anschließend werden pro Schicht mehrere MR-Bilder rekonstruiert, so dass für jedes Voxel innerhalb der Schichten jeweils ein MR-Signalverlauf (Fingerprint) erstellt werden kann, wie es in Fig. 2 dargestellt ist. Anhand dieses MR-Signalverlaufs werden dann die physikalischen Eigenschaften des jeweiligen Voxels bestimmt.

## Patentansprüche

1. Verfahren zum Erfassen von mindestens einem quantitativen physiologischen Parameter mit einer Magnetresonanzanlage (10) mittels MR-Fingerprinting,
wobei das Verfahren folgende Schritte umfasst:
gleichzeitiges Anregen von mehreren Schichten mit verschiedenen Bildgebungsparametern zur Erzeugung von MR-Signalverläufen in jeder der mehreren Schichten, und
gleichzeitiges Erfassen der MR-Daten der mehreren Schichten,
wobei bei dem gleichzeitigen Anregen der mehreren Schichten ein Flipwinkel (FW), mit welchem eine der mehreren Schichten angeregt wird, verschieden von einem Flipwinkel (FW) ist, mit welchem eine andere der mehreren Schichten angeregt wird.

2. Verfahren nach Anspruch 1,
**dadurch gekennzeichnet,**
**dass** ein Flipwinkelverlauf (FW₁-FW₅) jeder der mehreren Schichten derart eingestellt wird, dass die zur Erzeugung der Flipwinkelverläufe der gleichzeitig angeregten mehreren Schichten benötigte Leistung an die Leistungsgrenzen eines HF-Leistungsverstärkers (22) der Magnetresonanzanlage (10) angepasst ist.

3. Verfahren nach Anspruch 2,
**dadurch gekennzeichnet,**
**dass** eine Summe der Flipwinkel (FW), mit welchen die mehreren Schichten angeregt werden, zu jeder Zeit kleiner als ein vorgegebener Schwellenwert ist, welcher abhängig von den Leistungsgrenzen des HF-Leistungsverstärkers (22) definiert ist.

4. Verfahren nach Anspruch 2 oder 3,
**dadurch gekennzeichnet,**
**dass** eine Summe der Flipwinkel (FW), mit welchen die mehreren Schichten angeregt werden, zu jeder Zeit konstant ist.

5. Verfahren nach einem der vorhergehenden Ansprüche,
**dadurch gekennzeichnet,**
**dass** ein Flipwinkelverlauf (FW₁-FW₅) jeder der mehreren Schichten abhängig von einem Stoff eingestellt wird, dessen Eigenschaften anhand der zu erfassenden MR-Daten für die jeweilige der mehreren Schichten bestimmt werden.

6. Verfahren nach einem der vorhergehenden Ansprüche,
**dadurch gekennzeichnet,**
**dass** in einer ersten Phase des Verfahrens anhand von Ergebnissen einer Fingerprinting-Messung pro Schicht der mehreren Schichten jeweils ein Stoff bestimmt wird, und
**dass** in einer der ersten Phase folgenden zweiten Phase des Verfahrens ein Flipwinkelverlauf (FW₁-FW₅) jeder der mehreren Schichten abhängig von dem Stoff eingestellt wird, welcher für die jeweilige Schicht in der ersten Phase bestimmt wurde.

7. Magnetresonanzanlage, welche eine HF-Steuereinheit (14), einen HF-Leistungsverstärker (22), eine Gradientensteuereinheit (15), eine Bildsequenzsteuerung (16) und eine Recheneinheit (19) umfasst und zum Erfassen von mindesten einem quantitativen physiologischen Parameter mittels Fingerprinting ausgestaltet ist,
wobei die Magnetresonanzanlage ausgestaltet ist, um mittels der HF-Steuereinheit (14) und des HF-Leistungsverstärkers (22) gleichzeitig mehreren Schichten mit verschiedenen Bildgebungsparametern zur Erzeugung von MR-Signalverläufen anzuregen, und um mittels der Gradientensteuereinheit (15) und der Bildsequenzsteuerung (16) MR-Daten der mehreren Schichten gleichzeitig zu erfassen,
wobei die Magnetresonanzanlage (10) ausgestaltet ist, um bei dem gleichzeitigen Anregen der mehreren Schichten einen Flipwinkel (FW), mit welchem eine der mehreren Schichten angeregt wird, verschieden von einem Flipwinkel (FW) einzustellen, mit welchem eine andere der mehreren Schichten angeregt wird.

8. Magnetresonanzanlage nach Anspruch 7,
**dadurch gekennzeichnet,**
**dass** die Magnetresonanzanlage (10) zur Durchführung des Verfahrens nach einem der Ansprüche 1-6 ausgestaltet ist.

9. Computerprogrammprodukt, welches ein Programm umfasst und direkt in einen Speicher einer programmierbaren Steuereinrichtung (20) einer Magnetresonanzanlage (10) ladbar ist, mit Programm-Mitteln, um alle Schritte des Verfahrens nach einem der Ansprüche 1-6 auszuführen, wenn das Programm in der Steuereinrichtung (20) der Magnetresonanzanlage (10) ausgeführt wird.

10. Elektronisch lesbarer Datenträger mit darauf gespeicherten elektronisch lesbaren Steuerinformationen, welche derart ausgestaltet sind, dass sie bei Verwendung des Datenträgers (21) in einer Steuereinrichtung (20) einer Magnetresonanzanlage (10) das Verfahren nach einem der Ansprüche 1-6 durchführen.
